# EUROPEAN PATENT SPECIFICATION

(11) **EP 2 347 641 B1**
(45) Date of publication and mention of the grant of the patent: **07.06.2017**
(21) Application number: 09736390.7
(22) Date of filing: 23.09.2009
(51) Int. Cl.: H05K 5/00, H04N 5/64

(54) **A DISPLAY DEVICE**
ANZEIGEEINRICHTUNG
DISPOSITIF D'AFFICHAGE

(30) Priority: 08.10.2008 TR 200807565
(43) Date of publication of application: 27.07.2011
(73) Proprietor: Arçelik Anonim Sirketi, 34950 Istanbul (TR)
(72) Inventor: AYTEN, Serdar, 34950 Istanbul (TR); ACET, Bulent, 34950 Istanbul (TR); MERT, Gokhan, 34950 Istanbul (TR); KOCAMAN, Fatih, 34950 Istanbul (TR); HAMARAT, Derya, 34950 Istanbul (TR)
(86) International application number: PCT/EP2009/062303
(87) International publication number: WO 2010/040638

(56) References cited:
- EP-A2- 1 113 713
- WO-A1-2009/087518
- US-A- 5 455 743
- US-A- 5 742 359

## Description

### Field of the Invention

The present invention relates to a display device comprising a front cover and a keypad mounted to the front cover by means of a snap structure.

### Prior Art

The keypads provided on the display devices are mounted on the device in various ways. A commonly used solution is mounting the keypad to the front of the device by means of connecting members (screw, connector plastic piece, etc.) and/or snap structures. However these applications require a large working area inside the device during production for mounting the keypad, because in the process of installing in the device additional parts and/or snap structures used in mounting, the worker or the apparatus carrying out mounting should move in a large area relative to the size of the keypad. However with the developments in technology, sizes of the display devices are getting smaller day by day and there arises a requirement for mounting solutions that may be realized in confined spaces.

The United States patent document US5455743, an application within the state of the art, discloses a keypad attached to the television cabin. The keypad disposed in the opening located in the inner part of the front surface of the cabin is secured by screwing a bracket, which is covered on top of it, to the front surface.

The Japanese patent document JP8009298, in the state of the art, discloses a structure wherein the control unit is mounted to the television cabin without using an additional connecting member. Corrugated structures that will snap fit to each other are formed on the control unit and the cabin front panel. Thanks to these structures, the control unit is disposed into the corresponding openings provided on the front panel with a movement perpendicular to the screen.

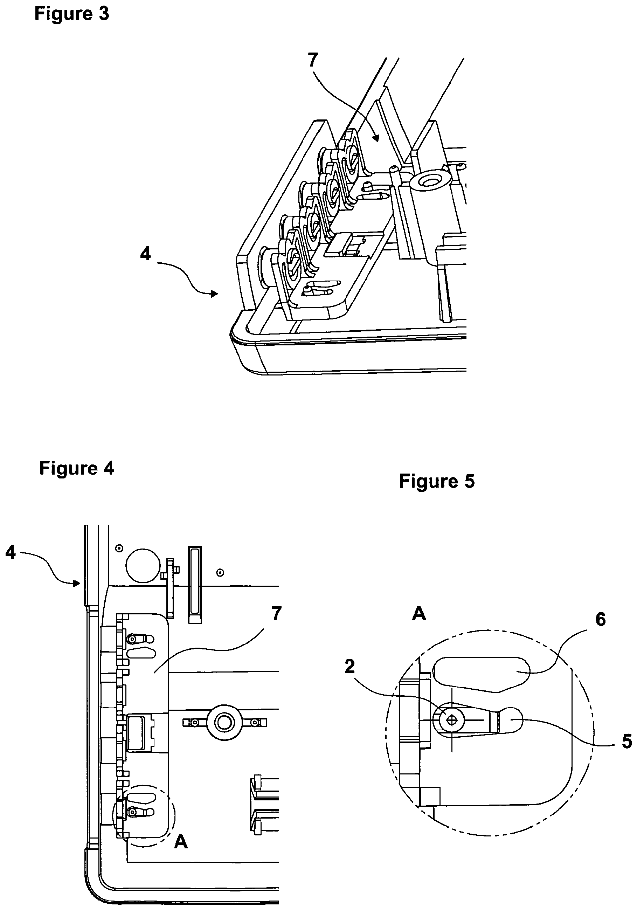

The document US 5 742 359 A discloses a display device with a front cover 70 which forms the front surface of the display device. A keypad 60 is mounted in the inner surface of the front cover 70, see Fig. 3. For mounting the keypad 60 to the front cover 70, the front cover comprises several pins 74 and the keypad comprises corresponding apertures 63. By this construction, the keypad 60 is mounted to the front cover 70 in such a manner that the pins 74 of the front cover 70 are forcibly tight-fitted in the corresponding apertures 63 of the keypad 60. Each pin 74 has a diameter slightly larger than that of each aperture 63 by about 0.3 to 0.4 mm. When each pin 74 is inserted into each corresponding aperture 63, it forcibly enlarges the aperture 63, thereby achieving the above-mentioned tight fitting. The enlargement of each aperture 63 is obtained by virtue of the slits 63a provided at both sides of each aperture 63.

### Summary of the Invention

The objective of the present invention is to realize a display device whose keypad can be mounted without requiring an additional connecting member and whereby production cost and time thereof are reduced.

Another objective of the invention is to realize a display device comprising a keypad which is easily mountable in a limited area of movement.

The display device and the keypad snap structure used in this device realized to fulfill the objective of the present invention and defined in Claim 1 and its dependent claims, enable the keypad to be mounted to the front cover without using any additional connecting member. Mounting is realized by the snap structure; which is comprised of a lock aperture constricted in the center, and narrow at one end and wide at the other; an expansion aperture; and the pin and support extension located on the front cover. The keypad is mounted on the front cover in two basic steps. The first step is to fit the keypad over its pins. In this step, the keypad is disposed on the front cover surface such that the pins pass though the wide parts of the lock aperture. The second step is the locking step wherein the keypad is tightly secured. Locking is realized by pushing the keypad towards the housing (edge of the cover). Upon pushing the keypad towards the said direction, the pin in the lock aperture moves from the wide part of the aperture to the narrow part and is tightly fitted into the aperture. Upon pushing of the keypad, during moving towards the narrow part, the pin passes through the constricted part, which is the narrowest part of the aperture, by exerting a power outwards of the aperture. By means of the expansion aperture right next to the lock aperture, the lock aperture slightly expands towards the expansion aperture whereby the pin is tightly fitted to the narrow part of the lock aperture. When passing through the constricted part, the pin encounters a force from the front to the back according to its movement direction. By means of a support extension formed adjacent to the pin, the pin is prevented from bending or twisting or breaking due to the said force and it is safely secured.

### Detailed Description of the Invention

The display device realized to fulfill the objective of the present invention is illustrated in the accompanying figures wherein,
Figure 1 is the perspective view of the inventive display device.
Figure 2 is the perspective view of a keypad and the area on the inner surface of the front cover where the keypad is to be mounted.
Figure 3 is the perspective view of the position of a keypad wherein it is disposed on the lock pins but not secured.
Figure 4 is the top view of a keypad in a position wherein it is disposed on the lock pins but not secured.
Figure 5 is the magnified view of the detail A in Figure 4.
Figure 6 is the perspective view of the keypad in a position wherein it is locked to the lock pins and secured to the front cover.
Figure 7 is the top view of the keypad in a position wherein it is locked to the lock pins and secured to the front cover.
Figure 8 is the magnified view of the detail B in Figure 7.

The components shown in the figures are numbered individually, where the numbers refer to the following:
1. Display device
2. Pin
3. Support extension
4. Front cover
5. Lock aperture
6. Expansion aperture
7. Keypad

The display device (1) comprises a front cover (4) forming the front surface of the outer cabin and having at least one lock pin (2) and at least one support extension (3); a keypad (7) mounted in the inner surface of the front cover (4) and having at least one lock aperture (5) and at least one expansion aperture (6); and a housing provided on the cover (4) into which the keypad (7) is fitted (Figure-1).

The front cover (4) is the part which surrounds the device screen. On the front and side surfaces of the front cover (4), there are control buttons used by the user for controlling the device.

The keypad (7) is the part which detects the commands given by the user by pressing/touching the buttons, and which converts these commands into an electrical signal and transfers them to the required units within the device. The keypad (7) is mounted to the inner surface of the front cover (4), into the housing (Figure-2).

The keypad (7) is mounted to the front cover (4) by fastening these two pieces (4, 7) to each other via a snap structure. Accordingly, the keypad (7) is secured by being placed onto the front cover (4) such that the lock pin (2) is inserted into the lock aperture (5) and locked by being pushed towards the surface including the control buttons.

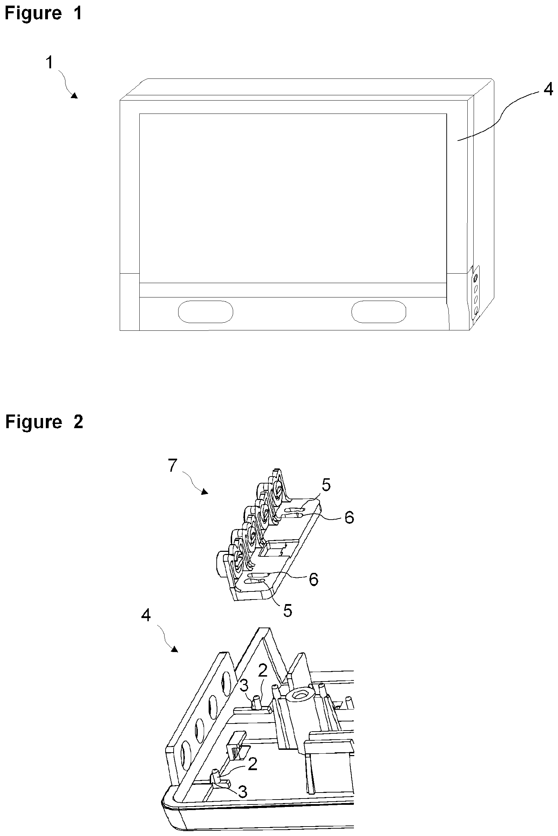

The lock pin (2) is located on the inner surface of the front cover (4) at the area where the control buttons are located, and preferably there are two of them (Figure 2). In order to increase resistance of the pin (2) against the force produced during pushing the keypad (7) for locking, there is provided a support extension (3) adjacent to each pin (2), which extension is located at the side of the pin (2) facing the control buttons.

The lock aperture (5) is in the form of an ellipse with a constricted part in the center thereof; and its one end is narrower than the other. It can be considered that the lock aperture (5) is comprised of combination of two circular apertures with different diameters. The expansion aperture (6) is located right next to the lock aperture (5) (preferably a few millimeters away) and it is an elliptical form with a protrusion parallel to the constriction of the lock aperture (5).

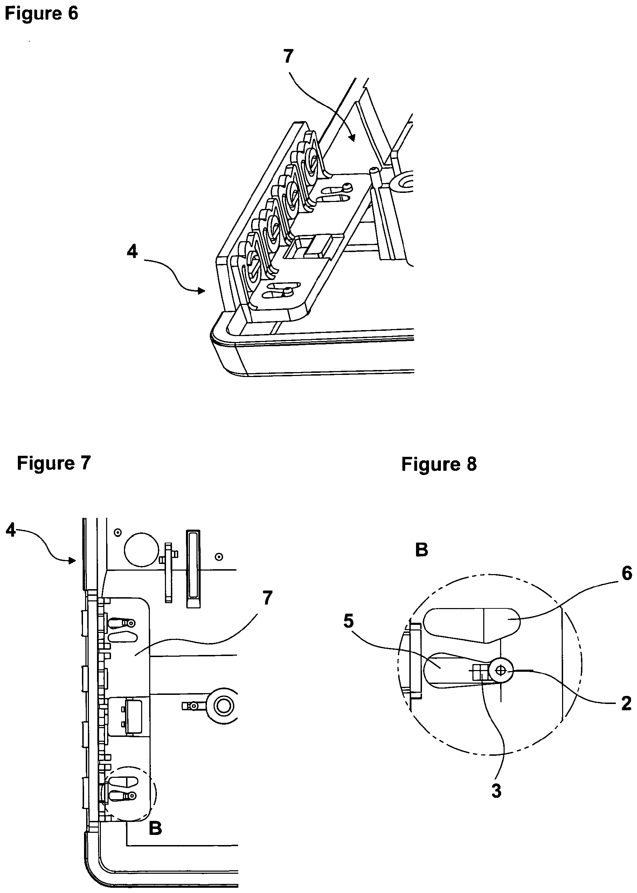

The keypad (7) is mounted to the front cover (4) in two steps. In the first step, the keypad (7) is placed over the pins (2) on the front cover (4) such that the pins (2) will fit thereinto; while in the second step, it is pushed towards the housing and locked. In the placement step, the keypad (7) is fitted onto the front cover (4) such that the pin (2) is inserted into the wide part of the lock aperture (5) (Figure 3, Figure 4, Figure 5). In the locking step, upon pushing of the keypad (7) towards the housing, the pin (2) in the lock aperture (5) passes through the constricted part and is tightly fitted into the narrow part of the lock aperture (5). In order for the pin (2) to be able to pass through the constricted part, the constriction should slightly expand outwardly. This expansion is realized by means of the expansion aperture (6). When the pin (2) is passing through the constriction, the expansion aperture (6) slightly shrinks to enable the lock aperture (5) to outwardly expand and the pin (2) to pass to the narrow part of the lock aperture (5). Thus the keypad (7) is locked and thereby firmly mounted to the front cover (4) (Figure 6, Figure 7, Figure 8). The support extension (3) adjacent to the pin (2) prevents the pin (2) from getting deformed due to the force it encounters when passing through the constriction.

Within the scope of this basic concept, it is possible to develop a wide variety of embodiments of the snap structure used in the device (1). The invention is essentially according to the claims and cannot be limited to the examples described herein.

## Claims

1. A display device (1) comprising a front cover (4) forming the front surface of the outer cabin and a keypad (7) mounted in the inner surface of the front cover (4); the front cover (4) having at least one pin (2); the keypad (7) having at least one lock aperture (5) into which the pin (2) is inserted during mounting of the keypad (7) to the front cover (4) and at least one expansion aperture (6); and a housing provided on the cover (4) into which the keypad (7) is fitted, **characterized in that** the keypad (7) is mounted to the front cover (4) via a snap structure, that the lock aperture (5) is in the form of an ellipse with a constricted part in the center thereof and whose one end is narrower than the other and is adapted to tightly fit the pin (2), and that the expansion aperture (6) is located next to the lock aperture (5) and has an elliptical form with a bulged part, wherein the edge of the expansion aperture (6) along the bulged part is parallel to the edge of the lock aperture (5) along the constricted part, allowing the constricted part of the lock aperture (5) to expand outwardly.

2. A display device (1) according to Claim 1 **characterized by** a front cover (4) having a support extension (3) which increases resistance of the pin (2) and which is in the form of an extension adjacent to the pin (2).

3. A display device (1) according to any of the preceding claims **characterized by** a keypad (7) which is disposed onto the front cover (4) such that the pin (2) will fit into the wide part of the lock aperture (5) and locked upon being pushed horizontally such that the pin (2) passes through the constriction and is secured to the narrow part of the lock aperture (5).

## Patentansprüche

1. Eine Anzeigevorrichtung (1), die eine Frontabdeckung (4) enthält, welche die vordere Fläche des äußeren Gehäuses bildet und eine an die Innenfläche der Frontabdeckung (4) angebrachtes Tastenfeld (7) umfasst; die Frontabdeckung (4) zumindest einen Stift (2) aufweist; wobei das Tastenfeld (7) mit zumindest je einem Verriegelungsschlitz (5) und einem Erweiterungsschlitz (6), für die Einführung des Stiftes (2) während der Halterung des Tastenfeldes (7) an die Frontabdeckung (4) versehen ist; wobei über der Frontabdeckung (4) ein Gehäuse (8) angeordnet ist und wobei im Innern der Abdeckung ein Tastenfeld (7) angeordnet ist; **dadurch gekennzeichnet, dass** das Tastenfeld (7) über eine Schnappverschlussstruktur an die Frontabdeckung (4) angebracht ist, der Verriegelungsschlitz (5) eine elliptischer Form mit einem schmalen Kanal in der Mitte aufweist, das eine Ende dieser Fassung schmäler als das andere ist, so dass der Stift (2) zum leichten Einsetzen geeignet adaptiert wird, wobei der Erweiterungsschlitz (6) am Verriegelungsschlitz (5) angeordnet ist und eine nach außen vorstehende elliptische Form aufweist, wobei hier entlang des vorstehenden Teils der schmale Kanalabschnitt des Erweiterungsschlitzes (6) parallel zum Rand des Verriegelungsschlitzes (5) ist und der schmale Teil in Form eines Kanals des Verriegelungsschlitzes (5) eine nach außen gerichtete Ausdehnung ermöglicht.

2. Eine Anzeigevorrichtung (1) nach Anspruch 1, **gekennzeichnet durch** eine Frontabdeckung (4), die einen zum Stift (2) benachbartem Vorsprung (3) aufweist, welcher den Widerstand des Stiftes (2) erhöht.

3. Eine Anzeigevorrichtung (1) nach einem der vorherigen Ansprüche, **gekennzeichnet durch** ein Tastenfeld (7), das auf der Frontabdeckung (4) angeordnet ist und wobei der Stift (2) in den breiten Teil des Verriegelungsschlitzes (5) passt, durch Drücken durch den schmalen Kanal geführt und im engen Teil des Verriegelungsschlitzes (5) befestigt wird und danach durch horizontales Durchdrücken des Stiftes (2) die Frontabdeckung verriegelt wird.

## Revendications

1. Dispositif d'affichage (1) comprenant un couvercle avant (4) formant la surface avant de la cabine extérieure et un clavier (7) monté dans la surface intérieure du couvercle avant (4); le couvercle avant (4) comportant au moins une tige (2); le clavier (7) comportant au moins une ouverture de verrouillage (5) dans laquelle est insérée la tige (2) pendant le montage du clavier (7) sur le couvercle avant (4) et au moins une ouverture de dilatation (6); et un logement (8) prévu sur le couvercle (4) dans lequel est monté le clavier (7), **caractérisé en ce que** le clavier (7) est monté sur le couvercle avant (4) par l'intermédiaire d'une structure à encliquetage, **en ce que** l'ouverture de verrouillage (5) se présente sous la forme d'une ellipse avec une partie rétrécie au centre de celle-ci et dont une extrémité est plus étroite que l'autre et est adaptée pour loger légèrement la tige (2), et **en ce que** l'ouverture de dilatation (6) est située à côté de l'ouverture de verrouillage (5) et présente une forme elliptique avec une partie bombée, dans laquelle le bord de l'ouverture de dilatation (6) le long de la partie bombée est parallèle au bord de l'ouverture de verrouillage (5) le long de la partie rétrécie, permettant à la partie rétrécie de l'ouverture de verrouillage (5) de se dilater vers l'extérieur.

2. Dispositif d'affichage (1) selon la revendication 1, **caractérisé en ce qu'**un couvercle avant (4) présente un prolongement de support (3) qui augmente la résistance de la tige (2) et qui se présente sous la forme d'un prolongement adjacent à la tige (2).

3. Dispositif d'affichage (1) selon l'une quelconque des revendications précédentes, **caractérisé par** un clavier (7) qui est disposé sur le couvercle avant (4) de telle sorte que la tige (2) s'adapte dans la partie large de l'ouverture de verrouillage (5) et bloqué en étant poussé horizontalement de sorte que la tige (2) passe par le rétrécissement et est fixée à la partie étroite de l'ouverture de verrouillage (5).
